Europäisches Patentamt

European Patent Office

Office européen des brevets

(11) Veröffentlichungsnummer: **0 415 085 A2**

# (12) EUROPÄISCHE PATENTANMELDUNG

(21) Anmeldenummer: 90114418.8

(22) Anmeldetag: 27.07.90

(51) Int. Cl.⁵: **H01L 21/48**

(30) Priorität: 01.09.89 DE 3928995

(43) Veröffentlichungstag der Anmeldung:
06.03.91 Patentblatt 91/10

(84) Benannte Vertragsstaaten:
**DE ES FR GB**

(71) Anmelder: **ROBERT BOSCH GMBH**
**Postfach 10 60 50**
**W-7000 Stuttgart 10(DE)**

(72) Erfinder: **Grothe, Brigitte**
**Talstrasse 19**
**W-7531 Lehningen(DE)**
Erfinder: **Grünwald, Werner, Dr. Dipl.-Phys.**
**Römerweg 8**
**W-7016 Gerlingen(DE)**
Erfinder: **Schmid, Kurt**
**Schlossstrasse 55**
**W-7257 Ditzingen 4(DE)**

(54) Verfahren zum Herstellen von Strukturen auf einem Substrat.

(57) Bei einem Verfahren zum Herstellen von Strukturen, wie beispielsweise Leiterbahnen, Widerstands- oder dielektrischen Strukturen, auf einem Substrat wird auf das Substrat eine photosensitive Schicht aufgebracht und diese mit einer Maske strukturiert. Danach werden die entsprechenden Vertiefungen durch Entwickeln freigelegt und sodann mit einer Paste aufgefüllt. Die photosensitive Schicht um die aufgefüllten Vertiefungen herum wird entfernt, so daß nur die Paste in Form der Struktur auf dem Substrat stehen bleibt.

Fig. 1

# VERFAHREN ZUM HERSTELLEN VON STRUKTUREN AUF EINEM SUBSTRAT

## Stand der Technik

Die Erfindung betrifft ein Verfahren zum Herstellen von Strukturen, wie beispielsweise Leiterbahnen, Widerstands-oder dielektrische Strukturen, auf einem Substrat.

Zur Herstellung von Strukturen auf einem Substrat ist beispielsweise das sogenannte PCS (photoformed ceramic substrate) -Verfahren bekannt. Bei diesem Verfahren handelt es sich um ein additives Verfahren. Ein gebranntes Substrat wird mit einem Photolack beschichtet und dieser über eine Maske belichtet. Hierdurch werden die freien Stellen klebrig und danach mit Metallpulver bestäubt. Das Metallpulver bleibt auf den klebrigen Stellen hängen, der Rest wird abgeschüttelt. Danach wird das so beschichtete Subtrat gebrannt, so daß geschlossene Leiterbahnen entstehen. Der Nachteil dieses Verfahrens liegt vor allem darin, daß zwar sehr feine Strukturen hergestellt werden können, daß aber mittels dieses Verfahrens nur eine Schichtdicke der Struktur von 4-5μ erreicht wird. Zudem werden bislang nur Goldstaub-Leiterbahnen erzeugt.

Als weiteres Verfahren ist das PCM (photoformed ceramic multilayered) -Verfahren bekannt, welches ein Substraktivverfahren ist. Hier gibt es insbesondere zwei Abwandlungen. Bei der einen Abwandlung wird eine Dickschichtpaste photoempfindlich gemacht und ganzflächig auf ein Substrat aufgedruckt. Danach wird diese Schicht photomaskiert und die Struktur ausgehärtet. Der Rest wird durch Spülen entfernt, so daß die Struktur allein stehen bleibt. Die Festigung der Struktur erfolgt durch Brennen. Bislang wurde dieses Verfahren nur mit Kupfer realisiert. Ferner sind hier Strukturen auf eine Breite von >100μ begrenzt, da das Licht in die Dickschichtpaste nicht weiter eindringen kann. Die Dicke liegt bei 10-20μ.

In einer Abwandlung dieses Verfahrens wird anstelle einer Dickschichtpaste eine Kunststoff-Folie, welche selbst lichtempfindlich und mit Metallpigmenten gefüllt ist, auf ein Substrat aufgewalzt, belichtet und der nicht belichtete Teil entfernt. Dieses Verfahren hat die gleichen Nachteile wie die Abwandlung mit der Dickschichtpaste.

Als weiteres Verfahren soll das MID-Filmverfahren genannt werden, welches ähnlich wie das PCS-Verfahren arbeitet, wobei jedoch die Organik anders ausgestaltet ist.

Des weiteren ist aus der US-4 508 753 ein Verfahren bekannt, bei dem auf das zu beschichtende Substrat eine zusätzliche Glas-Keramik-Schicht aufgebracht und diese mechanisch durch Fräsen oder Einprägen oder mit Laser bearbeitet wird. Mittels der mechanischen Bearbeitung erfolgt die Herstellung der Strukturen, jedoch nicht durchgehend bis auf das Substrat. Die zusätzliche Glas-Keramik-Schicht bleibt zudem beim Einbrennen der Dickschichtpaste stehen und erhalten.

## Vorteile der Erfindung

Das Verfahren gemäß der vorliegenden Erfindung hat den Vorteil, daß Strukturen beliebiger Höhe erzeugt werden können. Die Strukturen sind ferner deutlich schärfer als bei der Herstellung solcher Strukturen nach der konventionellen Dickschichttechnik. Bevorzugt wird die photosensitive Schicht in einer Dicke aufgebracht, welche der späteren Höhe der gewünschten Struktur entspricht. Als photosensitive Schicht kommt ein bekannter Positiv- oder Negativlack in Betracht. Dieser Positiv- oder Negativlack wird dann mittels einer Maske strukturiert, wobei auch hier je nach der Lackform eine Positiv- oder Negativmaske verwendet wird.

Durch Entwickeln erfolgt dann je nach der Strukturierung die Herstellung von Vertiefungen in der photosensitiven Schicht, wobei diese Vertiefungen durchgehen bis auf das Substrat, welches diese photosensitive Schicht trägt.

Zum Auffüllen der Vertiefungen kann eine handelsübliche Dickschichtpaste verwendet werden. Diese Dickschichtpaste wird bevorzugt mit einem Rakel auf die photosensitive Schicht aufgetragen und in die Vertiefungen eingerakelt. Als Rakel kann ein Stahlrakel oder ein Gummirakel verwendet werden. Mit dem Rakel wird dann oberflächlich die photosensitive Schicht wieder von der Paste soweit wie möglich gereinigt, so daß nur die Vertiefungen mit der Paste aufgefüllt sind. Danach erfolgt ein Einbrennen der Dickschichtpaste, wobei der verbliebene Photolack um die Vertiefungen bzw. um die Paste herum rückstandsfrei verbrennt. Es bleibt lediglich die gewünschte Struktur stehen, welche fest mit dem Substrat verbunden ist.

Die Vorteile der vorliegenden Erfindung liegen vor allem darin, daß zum einen handelsübliche Dickschichtpasten verwendet werden können und die Schichtdicke variierbar ist. In einem Versuch wurde eine Strukturhöhe von über 30μ ohne Schwierigkeiten erreicht.

Gegenüber dem PCS-Verfahren braucht bei dem erfindungsgemäßen Verfahren kein spezieller Toner verwendet werden, gegenüber dem PCM-Verfahren handelt es sich hier um ein Additivverfahren, welches immer Vorteile gegenüber dem Substraktivverfahren hat.

Zeichnungen

Weitere Vorteile, Merkmale und Einzelheiten der Erfindung ergeben sich aus der nachfolgenden Beschreibung eines bevorzugten Ausführungsbeispiels sowie anhand der Zeichnung; diese zeigt in

Figur 1 eine perspektivische Ansicht eines mit einer photosensitiven Schicht belegten Substrates,

Figur 2 eine perspektivische Ansicht des mit einer Struktur versehenen Substrates.

Das Substrat 1 kann dabei beispielsweise aus Aluminiumoxyd ($Al_2O_3$) bestehen, wobei jedoch auch andere geeignete Zusammensetzungen denkbar sind.

Auf dieses Substrat 1 ist die photosensitive Schicht 2 aufgebracht. Für das Herstellen dieser Schicht 2 kann beispielsweise ein Positiv- oder Negativlack verwendet werden. Das Aufbringen geschieht beispielsweise durch Siebdrucken oder Schleudern. Wesentlich ist, daß die Dicke der aufgebrachten Schicht 2 der gewünschten Trockenschichtdicke der später auf zubringenden Struktur entspricht.

Die photosensitive Schicht 2 wird nun in Abhängigkeit vom verwendeten Photolack mittels einer Positiv- oder Negativmaske strukturiert und so entwickelt, daß Vertiefungen 6 durchgehend durch die Schicht bis auf das Substrat 1 freigelegt werden.

Als nächster Verfahrensschritt erfolgt ein Fluten der Vertiefung 6 mit einer Paste 4, wobei diese Paste 4 oberflächlich mittels eines Rakels 5 abgerakelt wird. In den Vertiefungen 6 bleibt die Paste 4 in Kontakt mit dem Substrat 1 stehen.

Das Abrakeln kann beispielsweise mit einem Stahlrakel wie beim Tampondruckverfahren oder mit einem Gummirakel wie beim Siebdruckverfahren erfolgen.

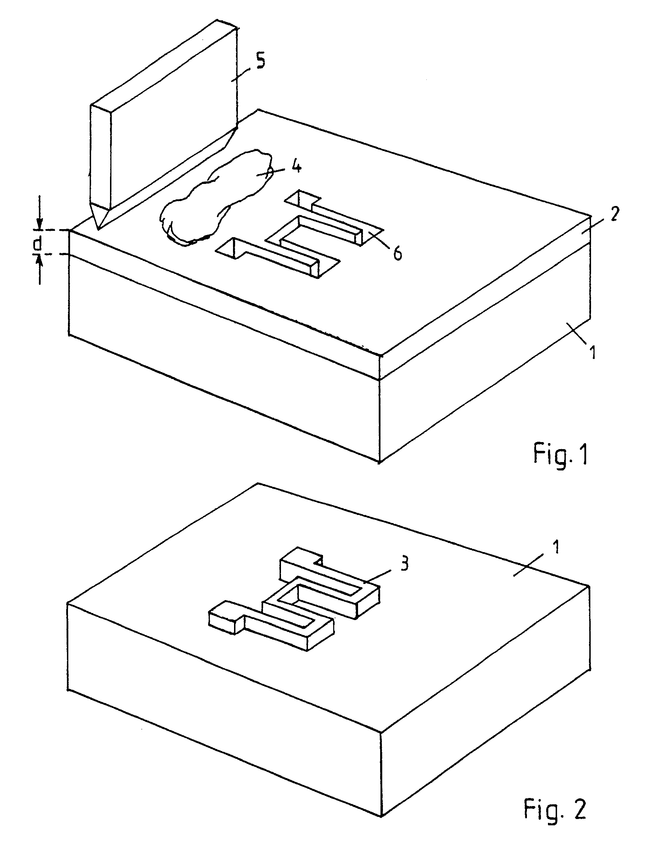

Die weiteren Verfahrensschritte entsprechen denjenigen der Standard-Dickschichttechnik. D. h., das mit der photosensitiven Schicht 2 belegte Substrat und die mit der Paste 4 gefüllten Vertiefungen 6 werden gebrannt und dann getrocknet. Beim Einbrennvorgang verbrennt die auf dem Substrat 1 verbliebene Schicht 2, d. h. der Photolack, rückstandsfrei. Stehen bleibt eine gewünschte Struktur 3, wie dies in Figur 2 näher gezeigt ist.

**Ansprüche**

1. Verfahren zum Herstellen von Strukturen, wie beispielsweise Leiterbahnen, Widerstands- oder dielektrische Strukturen, auf einem Substrat, dadurch gekennzeichnet, daß auf das Substrat eine photosensitive Schicht aufgebracht und diese mit einer Maske strukturiert wird, im Anschluß daran die entsprechenden Vertiefungen durch Entwickeln freigelegt und dann mit einer Paste aufgefüllt werden und die photosensitive Schicht um die aufgefüllten Vertiefungen entfernt wird.

2. Verfahren nach Anspruch 1, dadurch gekennzeichnet, daß ein Positiv- oder Negativlack als photosensitive Schicht und dementsprechend eine Positiv- oder Negativmaske zum Strukturieren verwendet wird.

3. Verfahren nach Anspruch 1 oder 2, dadurch gekennzeichnet, daß das Aufbringen der photosensitiven Schicht durch Siebdrucken oder Schleudern erfolgt.

4. Verfahren nach einem der Ansprüche 1 bis 3, dadurch gekennzeichnet, daß das Aufbringen der Schicht in einer Dicke erfolgt, welche der gewünschten Höhe der späteren Struktur in getrocknetem Zustand entspricht.

5. Verfahren nach wenigstens einem der Ansprüche 1 bis 4, dadurch gekennzeichnet, daß die Paste auf die photosensitive Schicht aufgerakelt wird, so daß sie die Vertiefungen füllt und mit dein Substrat in Kontakt kommt.

6. Verfahren nach wenigstens einem der Ansprüche 1 bis 5, dadurch gekennzeichnet, daß das Entfernen der photosensitiven Schicht nach dem Auffüllen der Vertiefungen durch Einbrennen erfolgt, wodurch die Paste als Struktur auf dem Substrat verbleibt.

Fig. 1

Fig. 2